# EUROPÄISCHE PATENTANMELDUNG

(11) **EP 0 706 223 A1**
(43) Veröffentlichungstag der Anmeldung: **10.04.1996**
(21) Anmeldenummer: 95114820.4
(22) Anmeldetag: 20.09.1995
(51) Int. Cl.: H01L 29/10, H01L 29/417

(54) **Durch Feldeffekt steuerbares Halbleiterbauelement**

(30) Priorität: 04.10.1994 DE 4435458
(71) Anmelder: SIEMENS AKTIENGESELLSCHAFT, D-80333 München (DE)
(72) Erfinder: Tihanyi, Jenö, Dr. Ing., D-85551 Kirchheim (DE)

(57) **Zusammenfassung**

Zwischen Sourceelektrode (8) und Basiszone (2) ist ein Kontaktbereich (10) mit höherer Leitfähigkeit als die Basiszone vorgesehen. Zur Verbesserung des Kontaktes zwischen Basiszone und Sourceelektrode ist der Kontaktbereich (10) als in der Basiszone vergrabene Schicht ausgebildet und ragt lateral über die Sourcezone (3) hinaus.

## Beschreibung

Die Erfindung bezieht sich auf ein durch Feldeffekt steuerbares Halbleiterbauelement mit mindestens einer Sourcezone, die in eine an die Oberfläche des Halbleiterkörpers angrenzende Basiszone eingebettet ist, mit mindestens einer parallel zur Oberfläche liegenden Gateelektrode, die mindestens den an die Oberfläche tretenden Teil der Basiszone überdeckt, mit einem mit der Basiszone verbundenen Kontaktbereich, der eine höhere Leitfähigkeit als die Basiszone hat, mit einer Elektrode, die die Sourcezone und den Kontaktbereich kontaktiert.

Alternativ bezieht sich die Erfindung auf ein durch Feldeffekt steuerbares Halbleiterbauelement mit mindestens einer Sourcezone, mit mindestens einer in einem vertikal zur Oberfläche liegenden Graben angeordneten vertikalen Gateelektrode, mit mindestens einer Basiszone, die seitlich an den Graben anstößt, mit einem Kontaktbereich, der eine höhere Leitfähigkeit als die Basiszone hat und elektrisch mit dieser verbunden ist, und mit einer Elektrode, die die Sourcezone und den Kontaktbereich kontaktiert.

Halbleiterbauelemente dieser Gattung sind z. B. in dem Artikel von Chang und Holroyd "High Voltage Power MOSFETS with a trench-gate structure" in Solid-State Electronics, Vol. 33, Nr. 3, 1990, Seiten 381 bis 386 beschrieben worden. Die Sourceelektroden kontaktieren die Sourcezonen direkt und die Basiszonen über Kontaktbereiche, die eine höhere Leitfähigkeit haben als die Basiszonen. Diese Kontaktbereiche dienen dazu, den Kontakt zwischen der Sourceelektrode und den Basiszonen zu verbessern. Die in dem Artikel beschriebenen Kontaktbereich sind so ausgebildet, daß aus dem Inneren des Halbleiterkörpers zur Sourceelektrode abfließende Minoritätsladungsträger in der niedrig dotierten Basiszone zum Teil entlang des pn-Übergangs zwischen Sourcezone fließen müssen. Die niedrige Dotierung verursacht hier einen hohen Spannungsabfall am pn-Übergang, der bei Überschreiten einer Größe von ca. 0,5 Volt eine Emission von Ladungsträgern aus der Sourcezone verursacht. Damit kann der aus Sourcezone, Basiszone und Innenzone bestehende parasitäre Bipolartransistor eingeschaltet werden und das Halbleiterbauelement wird zerstört.

Der Erfindung liegt die Aufgabe zugrunde, Halbleiterbauelemente der erwähnten Gattung so weiterzubilden, daß ein Einschalten des parasitären Bipolartransistors weitgehend vermieden wird.

Diese Aufgabe wird gemäß der ersten Alternative dadurch gelöst, daß der Kontaktbereich als in der Basiszone vergrabene Schicht ausgebildet ist und lateral über die Sourcezone hinaus ragt. Gemäß der zweiten Alternative wird die Aufgabe dadurch gelöst, daß der Kontaktbereich eine Tiefe hat, die größer ist als die der Sourcezone.

Weiterbildungen der Erfindung sind Gegenstand der Unteransprüche.

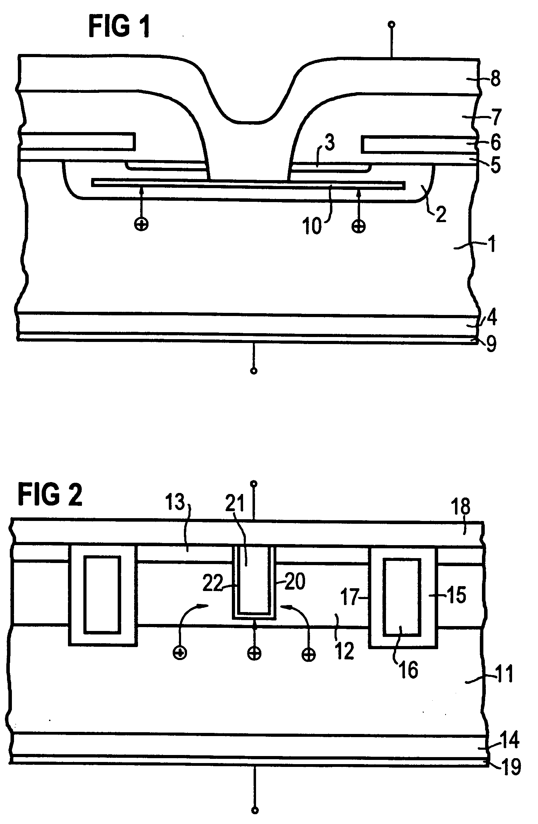

Die Erfindung wird anhand zweier Ausführungsbeispiele in Verbindung mit den Figuren 1 und 2 näher erläutert. Dabei zeigt Figur 1 den Schnitt durch ein Halbleiterbauelement mit horizontalem Gate und Figur 2 einen Schnitt durch ein Halbleiterbauelement mit einem sogenannten "Trench-Gate".

Im Ausführungsbeispiel nach Figur 1 ist die Innenzone des Halbleiterbauelements mit 1 bezeichnet. In die Innenzone 1 ist eine Basiszone 2 eingebettet. Diese grenzt teilweise an die obere Oberfläche des Halbleiterkörpers an. In die Basiszone 2 ist eine Sourcezone 3 eingebettet, die ebenfalls an die Oberfläche des Halbleiterkörpers angrenzt. Auf der von der Basiszone 2 abgewandten Seite der Innenzone 1 grenzt eine Anodenzone 4 an. Sie ist mit einer Elektrode 9 verbunden. Bei einem Halbleiterbauelement mit n-leitendem Kanal ergibt sich von der Sourcezone ausgehend die Zonenfolge n⁺pnn⁺ für einen Leistungs-MOSFET bzw. n⁺pnp⁺ für einen IGBT. Für ein Halbleiterbauelement mit p-Kanal sind die Leitfähigkeitstypen invers. Auf der sourceseitigen Oberfläche des Halbleiterkörpers ist eine erste Isolierschicht 5 aufgebracht. Auf dieser ist eine Gateelektrode 6 angeordnet. Die Gateelektrode 6 wiederum ist mit einer zweiten Isolierschicht 7 bedeckt. Zur Kontaktierung der Sourcezone 3 und der Basiszone 2 ist eine Elektrode 8 vorgesehen. Diese kontaktiert die Basiszone 2 durch ein in der Sourcezone 3 und in den Isolierschichten 5 und 7 vorgesehenes Kontaktfenster.

Zur Verbesserung des Kontaktes zwischen der Elektrode 8 und der Basiszone 2 ist in der Basiszone 2 ein Kontaktbereich 10 angeordnet, der eine höhere Leitfähigkeit als die Basiszone 2 hat. Der Kontaktbereich 10 ist einerseits mit der Elektrode 8 und andererseits mit der Basiszone 2 verbunden. Der Kontaktbereich 10 ist als vergrabene Schicht (Bur ied Layer) ausgebildet und ragt lateral über die Sourcezone 3 heraus. Er reicht jedoch nicht bis zur Oberfläche des Halbleiterkörpers, da dies die Einsatzspannung des Halbleiterbauelementes beeinflußt.

Die vergrabene Schicht kann z.B. ein sehr viel höher als die Basiszone 2 dotierter Halbleiterbereich vom Leitfähigkeitstyp der Basiszone 2 sein. Der Kontaktbereich 10 kann auch aus hoch dotiertem Polysilizium, aus einem Metallsilizid oder einem Metall bestehen.

Die im Inneren des Halbleiterkörpers erzeugten Minoriätsladungsträger, im Falle eines Halbleiterbauelementes vom n-Kanaltyp also Defektelektronen, fließen aus der Innenzone 1 zur Basiszone 2 und werden dort vom Kontaktbereich 10 eingefangen. Aus dem niederohmigen Kontaktbereich 10 fließen die Defektelektronen dann zur Elektrode 8 ab. Der dabei entstehende Spannungsabfall am pn-Übergang zwischen der Sourcezone 3 und der Basiszone 2 bleibt so niedrig, daß der Wert von 0,5 Volt nicht erreicht wird.

Das Halbleiterbauelement nach Figur 2 hat eine Innenzone 11, an die eine Basiszone 12 angrenzt. An die Basiszone 12 grenzt eine Sourcezone 13, die an die Oberfläche des Halbleiterkörpers tritt. Auf der von der Basiszone abgewandten Seite ist eine weitere Zone 14 vorgesehen, die im Falle eines Leistungs-MOSFET den gleich Leitungstyp wie die Innenzone 11 und im Falle eines IGBT den entgegengesetzten Leitungstyp hat. Sie ist mit einer Elektrode 19 verbunden.

In der Sourcezone 13 und der Basiszone 12 ist vertikal zur Oberfläche ein Graben 17 vorgesehen, in dem eine vertikale Gateelektrode 16 liegt. Die Gateelektrode 16 ist gegen die Basiszone 12 und die Sourcezone 13 durch eine Isolierschicht 15 elektrisch isoliert. Die Gateelektrode 16 überlappt die Sourcezone und die Innenzone 11 und erstreckt sich über die gesamte Tiefe der Basiszone 12.

Die Sourcezone 13 ist durch eine Elektrode 18 kontaktiert. Die Elektrode 18 kontaktiert auch die Basiszone 12 über einen Kontaktbereich 22. Dieser Kontaktbereich kann an den Wänden 20 eines sich von der Oberfläche in den Halbleiterkörper erstreckenden Graben 21 angeordnet sein. Der Kontaktbereich 22 ist einerseits mit der Elektrode 18 verbunden und steht andererseits mit der Basiszone 12 in Kontakt. Er hat eine höhere Leitfähigkeit als die Basiszone 12.

Aus der Innenzone 11 stammende Minoritätsladungsträger fließen dann über den Kontaktbereich 22 zur Sourceelektrode ab, anstatt parallel zwischen der Sourcezone 13 und der Basiszone 12 liegenden pn-Übergang zu fließen. Damit wird ein Einschalten des parasitären Bipolartransistors verhindert.

Der Kontaktbereich 22 kann z.B. durch Implantation von Borionen erzeugt werden, wenn die Basiszone 12 p-leitend ist.

Durch Streuung der zu implantierenden Ionen werden auch in die Wände 20 des Grabens 21 Ionen implantiert. Bei entsprechender Dosierung der Ionen ist es dann z.B. auch möglich, die Basiszone 12 durch Ausdiffusion der Borionen aus dem Kontaktbereich 22 zu erzeugen.

Der Kontaktbereich 22 kann z.B. auch aus dotiertem Polysilizium, einem Metallsilizid oder aus einem Metall bestehen. Der Kontaktbereich kann auch dadurch erzeugt werden, daß der Graben 21 gänzlich mit dotiertem Polysilizium oder Metall gefüllt wird. Er ist jedoch in jedem Fall tiefer als die Tiefe der Sourcezone 3, stößt jedoch nicht bis zur Innenzone 11 vor.

## Patentansprüche

1. Durch Feldeffekt steuerbares Halbleiterbauelement mit mindestens einer Sourcezone (3), die in einer an die Oberfläche des Halbleiterkörpers grenzende Basiszone (2) eingebettet ist, mit mindestens einer parallel zur Oberfläche liegenden Gateelektrode (6), die mindestens den an die Oberfläche tretenden Teil der Basiszone überdeckt, mit einem mit der Basiszone verbundenen Kontaktbereich (10), der eine höhere Leitfähigkeit als die Basiszone hat, mit einer Elektrode (8), die die Sourcezone und den Kontaktbereich kontaktiert,
**dadurch gekennzeichnet,** daß der Kontaktbereich (10) als in der Basiszone vergrabene Schicht ausgebildet ist und lateral über die Sourcezone (3) herausragt.

2. Durch Feldeffekt steuerbares Halbleiterbauelement mit mindestens einer Sourcezone (13), mit mindestens einer in einem vertikal zur Oberfläche liegenden Graben (17) angeordneten vertikalen Gateelektrode (16), mit mindestens einer Basiszone (12), die seitlich an den Graben anstößt, mit einem Kontaktbereich (22), der eine höhere Leitfähigkeit als die Basiszone hat und elektrisch mit dieser verbunden ist, und mit einer Elektrode (18), die die Sourcezone und den Kontaktbereich kontaktiert,
**dadurch gekennzeichnet,** daß der Kontaktbereich (22) eine Tiefe hat, die größer ist als die der Sourcezone (13).

3. Halbleiterbauelement nach Anspruch 1 oder 2,
**dadurch gekennzeichnet,** daß der Kontaktbereich (10, 22) ein dotierter Halbleiterbereich ist.

4. Kalbleiterbauelement nach Anspruch 1 oder 2,
**dadurch gekennzeichnet,** daß der Kontaktbereich (10, 22) aus dotiertem Polysilizium besteht.

5. Halbleiterbauelement nach Anspruch 1 oder 2,
**dadurch gekennzeichnet,** daß der Kontaktbereich (10, 22) aus einem Metallsilizid besteht.

6. Halbleiterbauelement nach Anspruch 1 oder 2,
**dadurch gekennzeichnet,** daß der Kontaktbereich (10, 22) aus einem Metall besteht.
